(19) Europäisches Patentamt / European Patent Office / Office européen des brevets

(11) **EP 4 191 877 A1**

(12) **EUROPEAN PATENT APPLICATION**

(43) Date of publication:
**07.06.2023 Bulletin 2023/23**

(21) Application number: **21212565.2**

(22) Date of filing: **06.12.2021**

(51) International Patent Classification (IPC):
$H03F\ 3/68^{(2006.01)}$    $H03F\ 3/24^{(2006.01)}$
$H03F\ 3/58^{(2006.01)}$    $H03F\ 1/52^{(2006.01)}$
$H03F\ 3/189^{(2006.01)}$   $H04B\ 1/74^{(2006.01)}$
$H03F\ 3/60^{(2006.01)}$

(52) Cooperative Patent Classification (CPC):
**H03F 1/526; H03F 3/189; H03F 3/24; H03F 3/58; H03F 3/602; H03F 3/68;** H03F 2200/192; H03F 2200/204; H03F 2200/451

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Eutelsat SA**
**92130 Issy Les Moulineaux (FR)**

(72) Inventors:
• **Le Pera, Alessandro**
**92130 Issy-Les-Moulineaux (FR)**
• **Castells Cervello, Antoni**
**92130 Issy-Les-Moulineaux (FR)**

(74) Representative: **Cabinet Camus Lebkiri**
**25 rue de Maubeuge**
**75009 Paris (FR)**

(54) **METHOD TO USE A MULTIPORT AMPLIFIER UNDER FAILURE CONDITION AND ASSOCIATED DEVICE**

(57) The invention relates to a method for using a multiport amplifier under failure condition, the multiport amplifier being onboard a satellite and providing output signals in frequency reuse, wherein a number of microwave amplifiers greater than the number of redundancy microwave amplifiers fails to provide proper amplification, thus creating, for each input signal, an interference replica signal on all output ports but one, the method being carried out by a communication device, the communication device storing at least a plurality of phase and level reference values of at least one reference signal received from each output port of the plurality of output ports of the multiport amplifier, the method comprising at least the steps of:
- generating at least one useful signal being destined to be input on at least one input port of the input ports of the multiport amplifier,
- generating at least one correction signal being destined to be input on a correction input port corresponding to an output port to improve, the correction signal being generated from:
- the useful signal,
- a predetermined phase value and
- a predetermined level value,
the predetermined phase value and the predetermined level value being chosen from the stored phase and level reference values associated to the reference signal received from the output port to improve,
- multiplexing the correction signal with the useful signal,
- emitting, towards the satellite, the multiplexed correction signal and useful signal.

**FIGURE 4**

**Description**

**TECHNICAL FIELD**

The technical field of the invention is the field of communication devices such as ground-based stations communicating with airborne satellites.

The present document concerns a method to use a multiport amplifier under failure condition. The present document concerns a method to improve the performance associated to the operation of a multiport amplifier under failure condition, and a communication device configured to transmit useful data to a satellite, the communication device compensating for at least part of the performance degradation associated to the failure of amplifiers of a multi-port amplifier onboard the satellite by applying the method of the invention.

**STATE OF THE ART**

Multiport amplifiers are often used in multi-beam satellites. These satellites are mainly used for mobile communications as they offer concurrent access to a large number of fixed and/or mobile terminals. A multibeam satellite provides several beams, the beams delivering signals to the terminals sent to the satellite by a gateway ground-based station.

The ground-based station sends signals to the satellite via an uplink feed and the satellite sends signals to the ground-based station via a downlink feed.

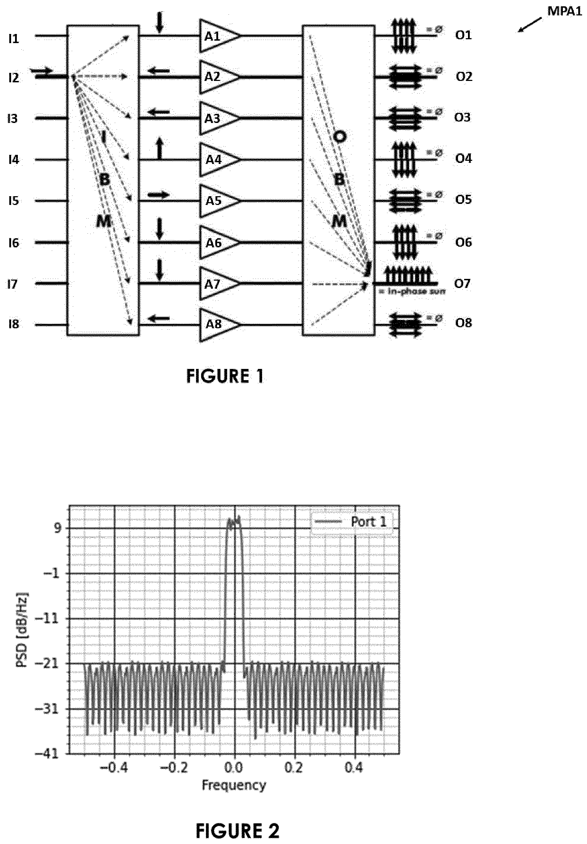

Multibeam satellites embed a multiport amplifier (MPA), the multiport amplifier comprising several amplifiers. Such a multiport amplifier is represented schematically at Figure 1. The 8-by-8 multiport amplifier MPA1 of Figure 1 comprises several input ports 11 to 18 and several output ports O1 to O8, linked by a route followed by incoming signals. A signal received at an input port 12, as shown at Figures 1 and 2, is amplified by several amplifiers A1 to A8 of the multiport amplifier between the input port and the output port. The replication of the signal provided to each of the amplifiers A1 to A8 is carried out using an "Input Butler Matrix" IBM which replicates the signal into 8 equi-level replicas, each exploiting a specific phase, multiple of 90 degrees as per following Table 1:

**Table 1: Butler Matrix phase relationship between Input (rows) and Output (columns) Ports**

| $IB_M=$ | 0 | -90 | -90 | 180 | -90 | 180 | 180 | 90 |
|---|---|---|---|---|---|---|---|---|
| | -90 | 180 | 180 | 90 | 0 | -90 | -90 | 180 |
| | -90 | 180 | 0 | -90 | 180 | 90 | -90 | 180 |
| | 180 | 90 | -90 | 180 | -90 | 180 | 0 | -90 |
| | -90 | 0 | 180 | -90 | 180 | -90 | 90 | 180 |
| | 180 | -90 | 90 | 180 | -90 | 0 | 180 | -90 |
| | 180 | -90 | -90 | 0 | 90 | 180 | 180 | -90 |
| | 90 | 180 | 180 | -90 | 180 | -90 | -90 | 0 |

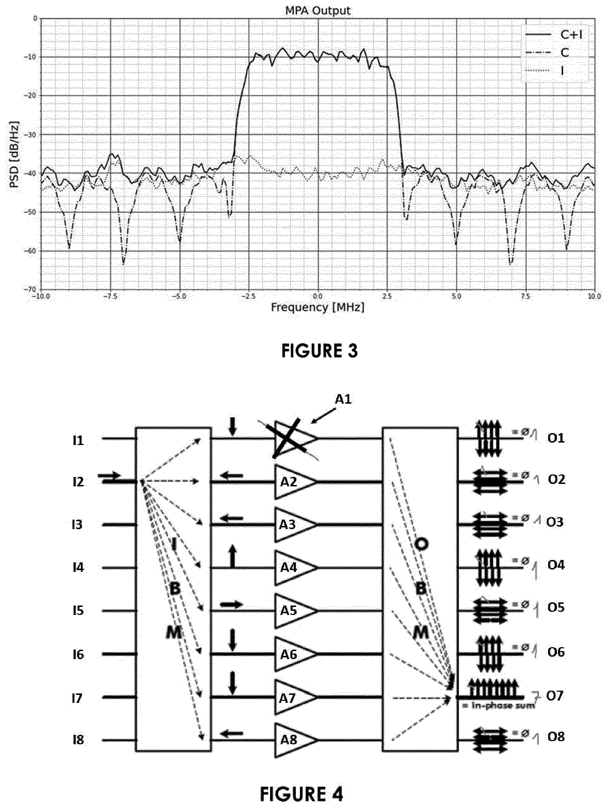

Each signal replica is amplified by the amplifiers A1 to A8 and, then, the 8 replica signals are provided in input to the Output Butler Matrix OBM. The Output Butler performs, for each of the 8 signals in input, the same processing as the IBM, i.e. division into 8 equi-level replicas, each with a precise phase shift multiple of 90 degrees. The net result is 64 equi-level input signal replicas provided at the OBM output, where, thanks to phase shifting, all the replicas delete one another on all ports (isolated ports) but one, named recombination port (O7 at Figure 1), where they sum up in phase. Figure 3 shows the resulting signals at output port O7, where the recombination port O7 comprises the output reconstructed and amplified signal, with I the interference signal, C the carrier signal and C+I the carrier signal + interference signal.

Ideally, the leakage of an output signal, corresponding to a given input signal, is null on all output ports but the recombination port, thus providing a perfect isolation among output ports, or infinite carrier-to-interference ratio C/I; in case the phase relationship between different signal replicas does not perfectly match, leakage of the output signal appears on all output ports, with levels depending on several factors. The ability to maintain the MPA port-to-port isolation within a given threshold is called MPA calibration.

Amplifiers A1 to A8 used in MPAs are for example linearized traveling-wave tube amplifiers. Traveling-wave tube amplifiers (TWTAs) are vacuum tubes able to amplify microwave signals. Linearized TWTA (LTWTA) are TWTAs to which have been added a linearizer. TWTAs are often used in MPAs as they permit to amplify large bandwidths. But TWTAs can experience failure in orbit.

The need of minimizing redundant hardware installed on a spacecraft because of mass and cost leads to consider the use of a multiport amplifier architecture that is optimized for a certain number of additionally installed TWTAs, where the overall architecture is designed around a provided "cold" redundancy so as to guarantee good performance in any redundancy case. Typical realizations are such that an 8 by 8 MPA (8 input ports and 8 output ports) contemplates the installation of 10 TWTAs with adequate "redundancy rings" for a redundancy TWTA to take over when a regular TWTA fails. The overall MPA performances are tuned, on ground as well as on-orbit, on the basis of a symmetrical MPA working with 8 TWTAs out of the 10 installed.

A problem arises when more TWTAs than the number of installed redundancy TWTAs fail. For example, in the previous example, when assuming that 3 TWTAs fail, the MPA is to be operated with 7 TWTAs. In case this happens, not only the overall output power is affected, but also the port-to-port isolation. The following examples permit to highlight the arising problems.

This first example concerns an 8 by 8 MPA, well calibrated, exploiting an average MPA isolation of 25 dB (average of the 7 isolated-port to recombination-port isolation). Such an MPA is shown at Figure 1 as previously described. The carrier to noise and interference ratio, which can be written C/(N+I), at an output port of the multiport amplifier can be expressed as a function of the noise to power ratio (NPR as provided by TWTA) and of the isolation of the multiport amplifier itself, as the thermal noise is not driving at this stage. It is also to be noted that the C/(N+I) ratio does not correspond to the final carrier to noise and interference ratio which is used to evaluate the effective capacity towards the user, also referred to as Quality of Service (QoS), as additional degradation factors appear such as antenna gain to evaluate the Effective Isotropic Radiated Power (EIRP), Antenna Isolation (an additional interferent term), free space loss and terminal gain to noise temperature (G/T).

By considering the noise to power ratio performance at different Output Back Off (OBO), the following table can be obtained:

**Table 2: nominal 8 by 8 MPA with 25 dB of isolation, NPR and C/(N+I) at different OBO**

| | OBO | NPR | MPA Isolation | C/(N+I) |
|---|---|---|---|---|
| **Nominal Case, 8 by 8 MPA, 25 dB** | **1.20** | 10 | 25 | **9.9** |
| | **1.60** | 11.5 | 25 | **11.3** |
| | **2.00** | 13 | 25 | **12.7** |
| | **2.40** | 14 | 25 | **13.7** |
| | **2.80** | 15 | 25 | **14.6** |
| | **3.20** | 16.1 | 25 | **15.6** |
| | **3.60** | 17.4 | 25 | **16.7** |

As it is clear from Table 2, the carrier to noise and interference ratio of the MPA output is mainly driven by the noise to power ratio, with a multiport amplifier having a good isolation.

The second example concerns an MPA suffering from TWTA failure beyond the installed redundancy. Typically, two redundancy LTWTAs are provided, which are able to replace any failed LTWTA by means of suitable redundancy switch rings. For this second example, a third LTWTA failure happens, which cannot be recovered.

Such an MPA failure is represented at Figure 4. Figure 4 shows what happens to a single signal in input at the input port 12, which for linearity can be extended to any number of signals on each port.

The absence of one amplifier A1 provokes a dissymmetry on the multiport amplifier's standard way of working, such that on all isolated output ports O1 to O6 and O8 one signal replica will not be deleted while, on the recombination output port O7, only 7 replicas instead of 8 are being summed in phase.

When in this case, the performance of the multiport amplifier suddenly degrades because of topology reasons:

- Output power degradation on each useful channel is 1.16 dB $\left(20 \log\left(\frac{7}{8}\right)\right)$

- MPA isolation expressed as carrier-to-interference ratio C/I is 16.9 dB $\left(\frac{20\log\left(\frac{7}{8}\right)}{\frac{1}{8}} = 20\log(7)\right)$

- As the MPA isolation is degraded because of topology reasons, the leakage appears on all the remaining 7 output ports

- The overall delivered output power is reduced of a factor (7/8), approximately 12.5%, associated to 7 working TWTA instead of 8; the output power associated to useful channels is reduced by approximately 23.5 %, where the remaining reduction is associated to power of the leakage signals (7 isolation signals, each of value approximately 18 dB down the useful signal)

By assuming that the overall link budget is not limited by the carrier-to-noise ratio but is rather driven by the carrier-to-interference ratio C/I, the degradation can be considered as causing:

- A traffic reduction of $10^{\frac{1,16}{20}}$ associated to the loss of radiofrequency power and assuming to deliver the same spectral density to traffic, equivalent to approximately 76.5 %

- A reduction on the C/(N+I) ratio associated to traffic, because of the degraded MPA isolation.

The final C/(N+I) ratio can be recovered by improving the noise to power ratio (NPR) to achieve the same "target" C/(N+I) ratio; as a consequence, the overall traffic that the multiport amplifier is able to manage gets further reduced because the LTWTA working point, i.e. the output backoff, needs to be increased to achieve such noise to power ratio improvement.

The Table 3 below shows the difference in output back-off (ΔOBO) to be considered to achieve the same final C/(N+I) per each OBO as in Table 1 but this time considering an MPA isolation of 17 dB, together with the percentage of traffic degradation.

**Table 3: evaluation of traffic degradation for a degraded MPA**

| | MPA isolation | C/ (N+I) | wanted C/(N+I) | NPR needed | Delta OBO needed | effective OBO | traffic degradation % |
|---|---|---|---|---|---|---|---|
| **Degraded MPA Isolation, 7 TWTA, 17 dB** | 17 | 9.2 | 9.9 | 10.8 | 0.21 | 1.41 | 27.1 |
| | 17 | 10.4 | 11.3 | 12.7 | 0.31 | 1.91 | 28.8 |
| | 17 | 11.5 | 12.7 | 14.8 | 0.71 | 2.71 | 35.0 |
| | 17 | 12.2 | 13.7 | 16.4 | 0.95 | 3.35 | 38.5 |
| | 17 | 12.9 | 14.6 | 18.3 | 1.20 | 4.00 | 41.9 |
| | 17 | 13.5 | 15.6 | 21.1 | 1.54 | 4.74 | 46.3 |
| | 17 | 14.2 | 16.7 | 28.5 | 2.28 | 5.88 | 54.7 |

The Table 3 second column provides the degraded C/(N+I) ratio with an MPA isolation of 17 dB (with respect to Table 1 per each OBO value), while the column "wanted C/(N+I)" is the target C/(N+I) ratio to guarantee the same quality of service "QoS" at user side as the quality of service of a standard working multiport amplifier. Therefore, a better TWTA noise to power ratio is needed, which is reported in column "NPR needed", to which corresponds an OBO increase to provide a final effective OBO and, thus, a traffic reduction, expressed in percentage in last column because of the further reduction in the overall delivered output power of the multiport amplifier.

As it can be seen, the impact can be relevant, where a common traffic offset of 23.5 % is associated to a total power reduction, the rest being linked to the need of improving the noise to power ratio to achieve the same final C/(N+I) ratio.

No method is currently known which can be adopted to achieve such an improvement on a multiport amplifier operating in degraded mode, that is with a number of working amplifiers inferior to its designed architecture.

The general approach to properly design a multiport amplifier is relevant to evaluate the cumulative Output Power needed to amplify the whole traffic as distributed on all the available ports of the multiport amplifier, which drives the number of amplifiers needed and then their rated radiofrequency power. Typical realizations follow 2^n power as number of elements, such that only 2 by 2, 4 by 4, 8 by 8 and, in the future, 16 by 16 multiport amplifiers are designed.

For example, with an 8 by 8 multiport amplifier, where typically two additional TWTA are installed; once the redundancy matrices have been tuned to guarantee good performance whatever the 8 TWTAs used out the set of 10 TWTAs, no method is known which is able to improve the performance of the multiport amplifier in case of a TWTA failure beyond the second TWTA.

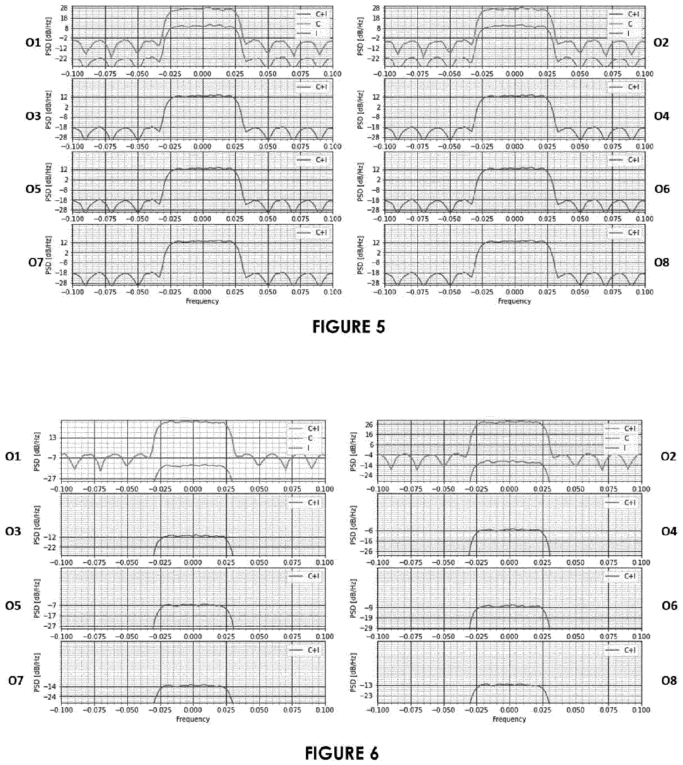

The problem is topological, and it cannot be solved by the calibrating of the multiport amplifier. This can be seen at Figures 5 and 6, which show respectively an ideal multiport amplifier under failure and a multiport amplifier under failure with a worst-case isolation. In Figures 5 and 6, two useful signals are injected respectively at input port 11 and input port 12, resulting in a useful signal on output port O1 and a useful signal on output port O2. Both multiport amplifiers experience leakage of the output signals on the other output ports, but with different level due to a different isolation. As only two output ports are effectively used, it is necessary to improve the performance of at least these two output ports.

There is therefore a need to be able to provide a working multiport amplifier with improved performances compared to the state of the art when the number of not working amplifiers is higher than the number of installed redundancy amplifiers.

**SUMMARY OF THE INVENTION**

The present document solves the above-mentioned problems by providing a solution to improve the performances of a multiport amplifier in a failure-condition where more than the number of installed redundancy amplifiers fail.

According to a first aspect of the invention, this is satisfied by providing a method for using a multiport amplifier under failure condition, the multiport amplifier being onboard a satellite, the multiport amplifier providing output signals in frequency reuse and comprising:

- a plurality of input ports, the multiport amplifier being configured to amplify input signals received on input ports,

- a plurality of microwave amplifiers, the plurality of microwave amplifiers comprising at least one redundancy microwave amplifier,

- an input Butler matrix configured to create replicas of the signal received at each of the input ports, each replica having a different phase and being routed towards a different microwave amplifier of the plurality of microwave amplifiers,

- a plurality of output ports,

- an output Butler matrix configured to combine, for each input signal, the replicas of the input signal amplified by the microwave amplifiers into one amplified output signal routed towards an output of the multiport amplifier,

wherein a number of microwave amplifiers fails to provide proper amplification, the number of failing microwave amplifiers being greater than the number of redundancy microwave amplifiers, thus creating, for each input signal, an interference replica signal on all output ports but one, the method being carried out by a communication device, the communication device storing at least a plurality of phase and level reference values of at least one reference signal received from each output port of the plurality of output ports of the multiport amplifier, the method comprising at least the steps of:

- generating at least one useful signal being destined to be input on at least one input port of the input ports of the multiport amplifier,

- generating at least one correction signal being destined to be input on a correction input port corresponding to an output port to improve, the correction signal being generated from:

  - the useful signal,

  - a predetermined phase value and

  - a predetermined level value,

  the predetermined phase value and the predetermined level value being chosen from the stored phase and level reference values associated to the reference signal received from the output port to improve,

- multiplexing the correction signal with the useful signal,

- emitting, towards the satellite, the multiplexed correction signal and useful signal.

Thanks to the invention, it is possible to improve the performance of a multiport amplifier in a failure condition. The invention allows, by being carried out by a communication device exterior to the satellite embedding the multiport amplifier, to be applied to existing satellites without any modification to the existing satellites. The invention is advantageously totally transparent to the satellite embedding the multiport amplifier.

The invention permits to re-establish suitable traffic conditions with a partial loss of traffic capacity rather than a total loss as depending on the number of failing equipments; as such, the percentage of "flat" traffic improvement or the percentage of "priority" traffic improvement largely compensates:

- the additional effort required by the invention:

    - cost of equipment,

    - installation in a ground-based gateway and

    - exploitation in the frame of satellite operations,

- the additional complexity, as the equipment should be able to access all the traffic intended to be sent to the multiport amplifier to select the relevant channels, processing them according to the proposed method and multiplex it onto the wanted useful traffic.

The invention is also flexible as it allows to choose between a complete correction of the interference signals due to the failing microwave amplifiers, or a partial correction depending on the wanted residual interference level on the output port and the wanted complexity to perform the method. The method also permits to choose only several output ports to correct, or to correct the leakage of only one useful signal.

The method of the invention may also have one or more of the following characteristics, considered individually or according to any technically possible combinations thereof:

- the predetermined level value is equal to the level reference value on the output port to improve.

- the predetermined level value is computed as a function of the residual interference level.

- the phase and level reference values are obtained from the Input Butler Matrix of the multiport amplifier and from the Output Butler Matrix of the multiport amplifier.

- the phase and level reference values are obtained by a measurement of a plurality of previously received reference signals, each reference signal being received from an output port of the plurality of output ports.

Another aspect of the invention relates to a communication system comprising:

- At least one satellite comprising at least one multiport amplifier comprising:

    - a plurality of input ports, the multiport amplifier being configured to amplify input signals received on input ports,

    - a plurality of microwave amplifiers, the plurality of microwave amplifiers comprising at least one redundancy microwave amplifier,

    - an input Butler matrix configured to create replicas of the signal received at each of the input ports, each replica having a different phase and being routed towards a different microwave amplifier of the plurality of microwave amplifiers,

    - a plurality of output ports,

    - an output Butler matrix configured to combine, for each input signal, the replicas of the input signal amplified by the microwave amplifiers into one amplified output signal routed towards an output of the multiport amplifier,

    - wherein a number of microwave amplifiers fails to provide proper amplification, the number of failing microwave amplifiers being greater than the number of redundancy microwave amplifiers, thus creating, for each input signal, an interference replica signal on all output ports but one,

- A device comprising at least one antenna and at least one modem, the device storing at least a plurality of phase and level reference values of at least one reference signal received from each output port of the plurality of output ports of the multiport amplifier and being configured to carry out the steps of the method according to any one of the preceding claims.

Another aspect of the invention relates to a computer program product comprising instructions which, when the program is executed by a computer, causes the computer to carry out the correction method according to the invention.

Another aspect of the invention relates to a computer-readable medium comprising instructions which, when executed by a computer, cause the computer to carry out the correction method according to the invention.

**BRIEF DESCRIPTION OF THE FIGURES**

Other characteristics and advantages of the invention will become clear from the description that is given thereof below, by way of indication and in no way limiting, with reference to the appended figures, among which:

- Figure 1 shows a schematic representation of a known standard multiport amplifier.

- Figure 2 shows a schematic representation of an input signal for a known standard multiport amplifier.

- Figure 3 shows a schematic representation of the output signal on an output port of a known multiport amplifier.

- Figure 4 shows a schematic representation of a known multiport amplifier experiencing failure.

- Figure 5 shows a schematic representation of the output of a known multiport amplifier calibrated to exploit a worst-case isolation value of approximately 30 dB.

- Figure 6 shows a schematic representation of the outputs of a known ideal multiport amplifier experiencing failure.

- Figure 7 shows a schematic representation of a communication system according to the invention.

- Figure 8 shows a schematic representation of the outputs of a known ideal multiport amplifier experiencing failure to which the method of the invention has been applied on input port 11 against leakage of a signal on input port 12.

- Figures 9A and 9B show respectively a multiport amplifier under failure to which the method of the invention has not been applied and to which the method of the invention has been applied.

- Figure 10 shows a schematical representation of the method according to the invention.

- Figure 11 shows a plot of the carrier-to-interference improvement as a function of the level difference between injected signal and interference signal.

**DETAILED DESCRIPTION**

For greater clarity, identical or similar elements are marked by identical reference signs in all of the figures.

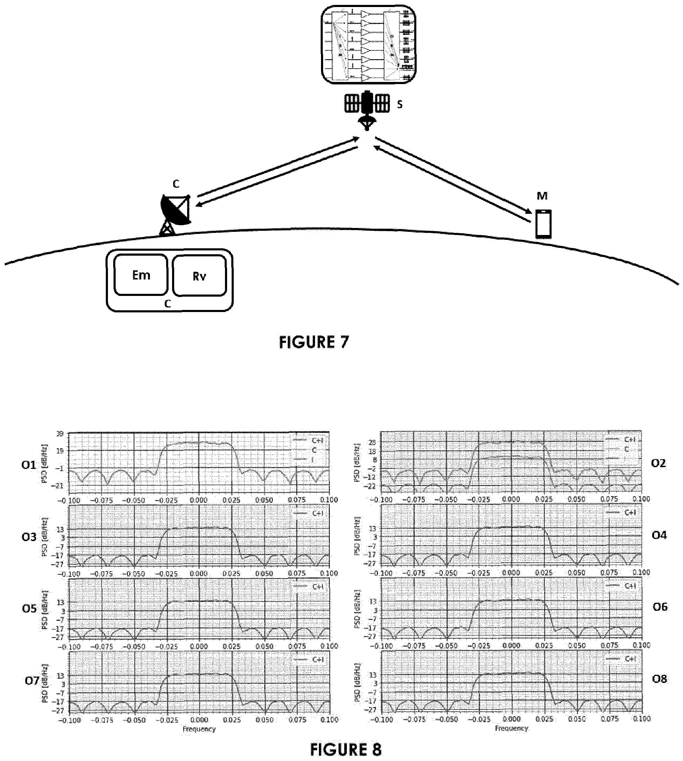

Figure 7 shows a schematic representation of a communication system according to the invention.

The communication system according to the invention comprises a satellite S and a device C. The system represented at Figure 7 further comprises a mobile device M which can for example be a user device, recipient of a communication to be transmitted by the device C.

In an embodiment, the device C is a communication device such as a ground-based station, for example a ground-based gateway, linked to a ground-based network (not shown). A communication incoming from the ground-based network and intended for the mobile device M has then to be transmitted by the communication C to the satellite S for relay to the mobile device M.

The communication device C comprises an emitting module such as an emitter Em and a receiving module such as a receiver Rv. Said emitting and receiving modules Em and Rv can be a single emitting/receiving module EmRv. The emitting and receiving modules Em and Rv comprise an antenna and a modem, the antenna enabling to receiving and send signals towards the satellite S and the modem enabling to modulate and demodulate received signals or to be sent signals.

In some embodiments, the communication device C can be airborne or spaceborne, or of any other type, as long as the communication device C has to communicate with the satellite S.

The satellite S is preferably a spaceborne satellite. The satellite S embeds at least one multiport amplifier (MPA), preferably in a communication payload. As presented in the state of the art, the multiport amplifier comprises microwave amplifiers such as traveling-wave tube amplifiers. For the rest of the description, the example of linearized TWTAs (LTWTAs) will be taken as microwave amplifiers of the multiport amplifier. The multiport amplifier permits to amplify several signals received on its input ports and to provide them on its output ports, for example as beams towards a celestial body.

The multiport amplifier further comprises input ports and outputs ports. The input ports and the LTWTAs are linked by an Input Butler Matrix IBM which creates replicas of the signal and routes the replicas towards the LTWTAS, and the LTWTAs and the output ports are linked by an Output Butler Matrix OBM which recreates the original signal but amplified on the right output port. The multiport amplifier comprises redundancy LTWTA, which, thanks to redundancy rings, can be used when another LTWTA fails. Cases of failure can be a broken piece, a too low amplification, or any other malfunction of the LTWTA which does not permit it to work as planned.

The invention is useful when more LTWTAs fail than the total number of redundancy LTWTAs. For example, for an 8-by-8 multiport amplifier, that is a multiport amplifier with 8 input ports and 8 output ports, with 8 LTWTA and 2 redundancy LTWTA, the invention is useful when more than 2 LTWTAs fail and permits to improve the performance of such a degraded multiport amplifier, that is to improve the traffic degradation with respect to worst case condition such as the condition as reported in Table 3, by improving the isolation of the multiport amplifier using interference cancellation techniques.

Figure 6 shows a schematical representation of resulting signals at the output ports of an MPA with 7 working LTWTA instead of 8. The represented output signals at output ports O1 and O2 result from two signals S1 and S2 being input for example at input ports 11 and 12 of the MPA.

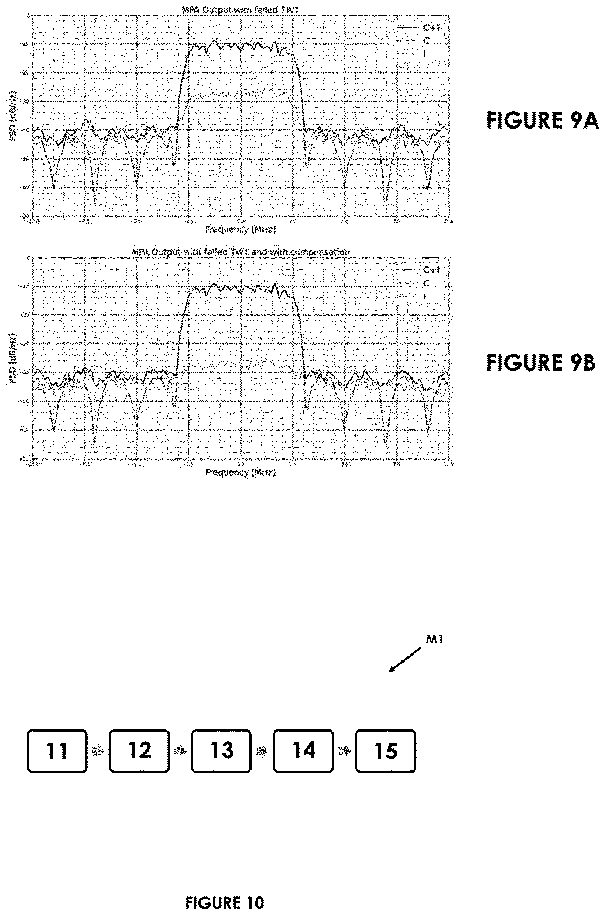

As it can be seen, the useful signal levels are degraded of approximately 1.1 dB, and, more importantly, a mutual leakage appears, consistent with previous evaluation that MPA isolation gets degraded to approximately 17 dB, as shown at Figure 9A. Further to that, the other output ports O3 to O8 are now providing an output signal, at a level of approximately 17 dBc with respect to output signals S1 and S2 respectively on O1 and O2.

In the invention, the communication device C is configured to send a plurality of useful signals, that is signals carrying useful data such as signals S1 and S2, destined to a user for example using mobile device M, towards the satellite S. At least one useful signal emitted by the communication device C is emitted together with at least one correction signal, the useful signal being destined to be input at an input port of the multiport amplifier embed in the satellite S and to be output at the corresponding output port as defined by the Butler Matrices. The at least one correction signal permits to null at least part of the interference replica signal created by the useful signal on a second output port. This second output port is chosen as an output port that needs a better performance, that is a lower interference replica signal level, for example because another useful signal as to be transmitted using this second output port. When all output ports need to be corrected, for example when useful signals have to be transmitted using all the output ports, the plurality of correction signals comprises a number of correction signals equal to the number of output ports of the multiport amplifier minus one, that is minus the input port (and corresponding output port) used by the useful signal. This permits to cancel, on each output port but the output port used by the useful signal, at least part of the resulting interference signal due to the useful signal leaking. Indeed, each correction signal has a given phase and amplitude to reduce the effect of the leak signal on the corresponding output port of the multiport amplifier. The interference signal is an interference replica signal on all output ports O1 to O8. In essence, the communication device C needed to implement the method of the invention is for example a Digital Transparent Processor with the ability to implement phase shifting at traffic channel and/or full bandwidth level in a multicast condition.

The optimal embodiment comprises centralizing all the traffic in a single gateway, so that the communication device C can have in input all the (baseband) traffic devoted to all the input ports of the multiport amplifier and on the basis of a selected optimization strategy, perform the following actions on a channel basis:

- Traffic channel selection: traffic to be protected, traffic in frequency reuse on other ports

- On the basis of mutual unbalance level, as reported on the output ports of the multiport amplifier or from reference values, : evaluation of the correction signal level to achieve the wanted improvement, Ai with i being the input port of the multiport amplifier;

- On the basis of the output port of the multiport amplifier to improve and of the phase mapping of the traffic to be injected on the corresponding input port, determination of fixed phase shifts $\ominus i$,

- Application of the correction signal level Ai and correction phase $\ominus i$ to the selected traffic destined to the multiport amplifier,

- Multiplexing of the complex signals onto useful traffic on input ports of the multiport amplifier to be improved.

This will further be explained later, the method of the invention comprising the determination of the level and phase of the correction signal to inject on an input port of the multiport amplifier.

A first example of the addition of a single correction signal will be taken. A single correction signal is multiplexed to a single useful signal to correct the leakage of the useful signal on an output port that is to be corrected, that is for which an interference level is to be reduced.

This example of the invention injects the correction signal $S2_{injected}$, a replica of the useful signal S2, multiplexed on input port 11 with the input signal S1. By considering a level difference of 17dB between S1 and S2, adequate to null the corresponding interference signal $S2_{int}$ appearing on O1, and proper phasing, the following can be said:

- On output port O1, $S2_{inj}$ perfectly nulls S2int as shown at Figure 8,

- On output port O1, the C/(N+I) ratio gets improved,

- $S2_{inj}$ also leaks onto other output ports of the multiport amplifier, in accordance with the multiport amplifier degraded isolation model, with an additional 17dB reduction on each output port,

- On output port O2, the interference signal S2ininjint created by the injected correction signal $S2_{inj}$ on input port 11 combines with the useful signal S2, but $S2_{injint}$ is approximately 34 dB lower than S2 in level, so the multipath effect is negligible.

The positive effect of the invention on the output port O1 is evident, and a comparison of between before applying the method of the invention and after applying it is shown respectively at Figures 9A and 9B. Furthermore, as shown at Figure 8, it is possible to appreciate the negligible effect on all other output ports, including output port O2 where the useful signal S2 is present and combining with $S2_{injint}$.

The invention covers any case where at least one useful signal is sent together with at least one correction signal to correct the interference signal on an output port of a multiport amplifier different than the output port with the useful output signal, the interference signal being caused by at least one more microwave amplifier failing than the total number of redundancy amplifier of the multiport amplifier.

In an example where all the input ports of an 8-by-8 multiport amplifier are used, that is when all input ports receive each an input signal, and where it is wanted to null or at least remove part of the interference signals on all output ports, the invention comprises the sending of 8 useful signals and 56 correction signals, comprising 7 correction signals for each useful signal, each useful signal being destined to one input port and each correction signal sent together with said useful signal being destined to the other input ports, so as to null or at least partly remove the interference signal resulting from the useful signal on the other output ports.

This description makes the assumption that phase and level values of the interference replica signals on all the output ports of the multiport amplifier are known by the device C carrying out the invention. This knowledge can be obtained in several ways.

First, during a calibration of the multiport amplifier, it is possible to know the phase and level of the output signals on all the output ports. It is understood by "level" the power of the output signal. These phase and level values are called "reference phase and level values" as they are related to a phase and to a level of a reference signal sent to the multiport amplifier to determine reference phase and level values on each output port of the multiport amplifier. These phase and level reference values can be hardcoded in the memory M of the communication device C carrying out the method M1 according to the invention. They can also be stored in a memory or a server comprised in a network to which the communication device C is connected. Another way to obtain knowledge of the phase and level values of the signals on the output ports of the multiport amplifier is to observe the signals on the output ports of the multiport amplifier by receiving them. This can be done via one associated device or a plurality of associated devices or directly by the communication device C. Both these embodiments allow the communication device C to know the interference level and phase of the signals on the different output ports of the multiport amplifier to be able to counterbalance the interference signals on the desired output ports. The invention covers the cases where the improvement of the output signal on one, several or all output ports is targeted. The received output signal or signals comprise interference replica signals, which have been created by the multiport amplifier due to the failure of at least one microwave amplifier.

The invention comprises determining a correction policy of the multiport amplifier. This policy comprises the output port to improve and how it is wanted for it to be improved. This can be performed by obtaining, from a database or from a memory of the communication device C, a policy comprising the output ports to improve and a wanted residual interference level. This policy can be hardcoded in the device or can be retrieved from a distant database or sent to the communication device C. This policy can be computed dynamically, for example as a function of use of the different output ports and of the actual interference level on the output ports.

Such policies can be based on strategies, some of them can be comprised in the following, but are not limited to:

- Whole traffic capacity improvement: in cases where the final quality of service of the user is driven by the carrier-to-interference ratio (MPA isolation, noise to power ratio, antenna the carrier-to-interference ratio) more than by the carrier-to-noise ratio (MPA output power, EIRP, terminal gain-to-temperature ratio), the overall isolation of the multiport amplifier can be improved, where correct trade-off among C/(N+I) ratio improvement and output backoff increase has to be evaluated,

- Specific traffic channel improvement: in cases where specific traffic channel need priority and are profiting of adequate carrier-to-noise ratio, the carrier-to-interference ratio needs to be improved not to degrade the overall C/(N+I) ratio; by evaluating the mutual interference plan in the frequency reuse scheme, adequate selective interference injection strategy can be deployed,

- As a second order traffic improvement approach and thanks to the inherent flexibility of the proposed method, a more detailed performance trade-off can be exploited by considering the mobile device M locations and specific Antenna Gain and carrier-to-interference ratio, noise-to-power ratio specific performance in the bandwidth of interest as associated to traffic in frequency reuse and in adjacent traffic bands, eventual margins in MPA delivered output power which can be flexibly swapped among traffic channels.

Such strategies can permit to determine a residual interference level to adapt the level of the corrected signal as a function of the wanted performance improvement.

The method according to the invention is schematically represented at Figure 10. This method M1 is carried out by the device C, preferably the device C being comprised in a ground-based station or being a ground-based station. As explained previously, the communication device C stores at least a plurality of phase and level reference values of at least one reference signal received from each output port of the plurality of output ports of the multiport amplifier. This will be used to generate at least one correction signal.

The method M1 comprises a step 11 of generating at least one useful signal being destined to be input on at least one input port of the input ports of the multiport amplifier. This input port corresponds to an output port, that is the useful signal injected on the input port, for example 11, will be output at the corresponding output port, for example O1.

The method M1 then comprises a step 12 of generating at least one correction signal being destined to be input on a correction input port corresponding to an output port to correct, the correction signal being generated from:

- the generated useful signal,

- a predetermined phase value and

- a predetermined level value,

the predetermined phase value and the predetermined level value being chosen from the stored phase and level reference values associated to the reference signal received from the output port to improve. The phase is determined as a function of the output port to improve, that is the opposite phase or near opposite phase to the phase of signals outputted at the output port to improve will be chosen, and the level is determined as a function of the wanted improvement, as described previously in link with the policy.

The level of the injected correction signal can be fixed, based on a reference level. Reference level values can be obtained using a reference signal for example during calibration of the multiport amplifier. The level of the injected correction signal can instead depend on a level measurement of a previously received signal from the output port to be improved. Knowing the fixed or dynamically-determined level of the interference replica signal, the level of the injected correction signal can be chosen on the basis of the wanted improvement, or in other words the wanted residual level of the interference replica signal on the output port:

- With the same level between the correction signal and the interference replica signal, a perfect interference nulling is obtained, that is no interference replica signal on the wanted output port, the wanted output port being related to the input port the correction signal is injected on. For example, input port 11 is related to output port O1, but other relationships between input and output ports can exist.

- With a reduced level of the correction signal as compared to the level of the interference replica signal, assuming $S_{int}$ is the level of interference replica signal on the output port to improve and $S_{inj}$ is the level of the injected correction signal as seen on the output port to improve, the residual interference level Sres can be computed according to

$$\text{Sres} = S_{inj} + 20Log\left(1 - 10^{\left(\frac{Sint - Sinj}{20}\right)}\right)$$ with all the levels expressed in dB. Assuming S1 being the level of the useful signal, the final carrier-to-interference ratio is therefore given by (S1- Sres)dB

The predetermined phase of the correction signal, is determined as a function of the stored reference fixed phase values or dynamic phase values, wherein the dynamic phase values have been obtained by at least one associated device (not represented).

The phase of the injected correction signal can be fixed and dictated by phase evolutions across Input and Output Butler matrices. Having a predetermined fixed phase value is performed based on reference phase values obtained using a reference signal for example during calibration of the multiport amplifier. The phase of the injected correction signal can instead depend on a phase measurement of a previously received signal from the output port to be improved. In case of continuous wave signals, it is possible to search and use the exact opposite phase, but for bandpass signals, an average phase over the bandwidth of the signal should be used.

The step 12 is carried out for each needed correction signal corresponding to an output port to improve, that is:

- If y useful signals have to be sent and z output ports have to be improved, for an x-by-x multiport amplifier, for each of the y useful signals:

  - z-1 correction signals if the useful signal is not destined to the input port corresponding to an output port to be improved, that is one correction signal for each input port of the multiport amplifier corresponding to an output port to be improved,

  - z-2 correction signals if the useful signal is destined to an input port corresponding to an output port to be improved, that is one correction signal for each input port of the multiport amplifier corresponding to an output port to be improved except for the input port to which the useful signal is destined.

The method M1 then comprises a step 14 of multiplexing the correction signal(s) with the useful signal(s) to be sent.

The method M1 then comprises a step 15 of emitting, towards the satellite, the multiplexed correction signal and useful signal.

In order to evaluate the improvement to traffic associated to the proposed approach of the invention, an evaluation has been carried out with a target consisting in the same final C/(N+I) ratio. Therefore, the needed noise to power ratio is less constraining and the difference in output backoff (ΔOBO) gets reduced. The starting point is the traffic degradation associated to the degraded multiport amplifier with approximately 17 dB of isolation among all ports, as shown in the second and third columns of Table 4.

Table 4: Traffic degradation improvement vs MPA isolation improvement

| C/(N+I) | MPA Isol | Traffic degradation % | MPA Isol | Traffic degradation % | MPA Isol | Traffic degradation % | MPA Isol | Traffic degradation % | MPA Isol | Traffic degradation % |
|---|---|---|---|---|---|---|---|---|---|---|
| 9.9 | | 27 | | 26 | | 25 | | 25 | | 24 |
| 11.3 | | 29 | | 27 | | 26 | | 25 | | 25 |
| 12.7 | | 35 | | 32 | | 30 | | 28 | | 26 |
| 13.7 | 17 | 39 | 18 | 34 | 19 | 31 | 20 | 29 | 21 | 27 |
| 14.6 | | 42 | | 36 | | 33 | | 30 | | 28 |
| 15.6 | | 46 | | 39 | | 34 | | 31 | | 28 |
| 16.9 | | 55 | | 40 | | 35 | | 33 | | 32 |

As it can be seen in Table 4, the improvement is important and more pronounced for higher values of C/(N+I) as associated to higher output backoff.

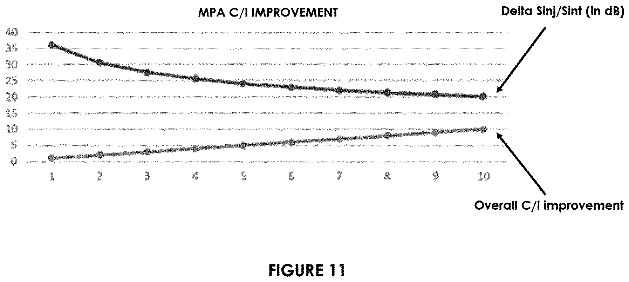

Depending on the relative level between the injected signal and the interference signal ($S2_{inj}$ - $S2_{int}$), the carrier-to-interference ratio C/I gets improved targeting a wanted value, thus determining the wanted traffic capacity improvement. This is represented at Table 5 and Figure 11.

**Table 5: C/I improvement compared to level difference between $S_{inj}$ and $S_{int}$**

| S2int on S1 O/P port (dBc) | -16.9 | -16.9 | -16.9 | -16.9 | -16.9 | -16.9 | -16.9 | -16.9 | -16.9 | -16.9 |
|---|---|---|---|---|---|---|---|---|---|---|
| S2inj on S1 O/P port (dBc) | -17.9 | -18,9 | -19.9 | -20.9 | -21.9 | -22.9 | -23.9 | -24.9 | -25.9 | -26.9 |
| Delta (dB) | 1 | 2 | 3 | 4 | 5 | 6 | 7 | 8 | 9 | 10 |
| Sres | -19.3 | -13.7 | -10.7 | -8.7 | -7.2 | -6.0 | -5.1 | -4.4 | -3.8 | -3.3 |
| C/I improv | 36.2 | 30.6 | 27.6 | 25.6 | 24.1 | 22.9 | 22.0 | 21.3 | 20.7 | 20.2 |

The invention can be applied to any multiport amplifier comprised in a satellite, even in existing multiport amplifiers and existing satellites, as the invention is carried out by a device exterior to the satellite S. The interference injection method of the invention is a wide-band method as the Output Butler Matrix phase versus frequency is quite flat and the phase relation between the interference replica signal appearing on the output port and the injected correction signal on the input port have a stable relationship across the frequency bandwidth, which is not depending on the overall multiport amplifier calibration.

**Claims**

1. Method for using a multiport amplifier under failure condition, the multiport amplifier being onboard a satellite, the multiport amplifier providing output signals in frequency reuse and comprising:

   - a plurality of input ports, the multiport amplifier being configured to amplify input signals received on input ports,
   - a plurality of microwave amplifiers, the plurality of microwave amplifiers comprising at least one redundancy microwave amplifier,
   - an input Butler matrix configured to create replicas of the signal received at each of the input ports, each replica having a different phase and being routed towards a different microwave amplifier of the plurality of microwave amplifiers,
   - a plurality of output ports,
   - an output Butler matrix configured to combine, for each input signal, the replicas of the input signal amplified by the microwave amplifiers into one amplified output signal routed towards an output of the multiport amplifier,

   wherein a number of microwave amplifiers fails to provide proper amplification, the number of failing microwave amplifiers being greater than the number of redundancy microwave amplifiers, thus creating, for each input signal, an interference replica signal on all output ports but one, the method being carried out by a communication device, the communication device storing at least a plurality of phase and level reference values of at least one reference signal received from each output port of the plurality of output ports of the multiport amplifier, the method comprising at least the steps of:

   - generating at least one useful signal being destined to be input on at least one input port of the input ports of the multiport amplifier,
   - generating at least one correction signal being destined to be input on a correction input port corresponding to an output port to improve, the correction signal being generated from:

      - the useful signal,
      - a predetermined phase value and
      - a predetermined level value,

   the predetermined phase value and the predetermined level value being chosen from the stored phase and level reference values associated to the reference signal received from the output port to improve,
   - multiplexing the correction signal with the useful signal,

- emitting, towards the satellite, the multiplexed correction signal and useful signal.

2. Method according to the preceding claim **characterized in that** the predetermined level value is equal to the level reference value on the output port to improve.

3. Method according to claim 1 **characterized in that** the predetermined level value is computed as a function of the residual interference level.

4. Method according to any one of the preceding claims **characterized in that** the phase and level reference values are obtained from the Input Butler Matrix of the multiport amplifier and from the Output Butler Matrix of the multiport amplifier.

5. Method according to any one of claims 1 to 3 **characterized in that** the phase and level reference values are obtained by a measurement of a plurality of previously received reference signals, each reference signal being received from an output port of the plurality of output ports.

6. Communication system comprising:

- At least one satellite comprising at least one multiport amplifier comprising:

- a plurality of input ports, the multiport amplifier being configured to amplify input signals received on input ports,
- a plurality of microwave amplifiers, the plurality of microwave amplifiers comprising at least one redundancy microwave amplifier,
- an input Butler matrix configured to create replicas of the signal received at each of the input ports, each replica having a different phase and being routed towards a different microwave amplifier of the plurality of microwave amplifiers,
- a plurality of output ports,
- an output Butler matrix configured to combine, for each input signal, the replicas of the input signal amplified by the microwave amplifiers into one amplified output signal routed towards an output of the multiport amplifier,
- wherein a number of microwave amplifiers fails to provide proper amplification, the number of failing microwave amplifiers being greater than the number of redundancy microwave amplifiers, thus creating, for each input signal, an interference replica signal on all output ports but one,

- A device comprising at least one antenna and at least one modem, the device storing at least a plurality of phase and level reference values of at least one reference signal received from each output port of the plurality of output ports of the multiport amplifier and being configured to carry out the steps of the method according to any one of the preceding claims.

7. Computer program product comprising instructions which, when the program is executed by a computer, causes the computer to carry out the method according to claims 1 to 5.

8. Computer-readable medium comprising instructions which, when executed by a computer, cause the computer to carry out the method according to claims 1 to 5.

FIGURE 1

FIGURE 2

15

**FIGURE 3**

**FIGURE 4**

EP 4 191 877 A1

FIGURE 5

FIGURE 6

**FIGURE 7**

**FIGURE 8**

MPA Output with failed TWT

FIGURE 9A

MPA Output with failed TWT and with compensation

FIGURE 9B

M1

11 ➡ 12 ➡ 13 ➡ 14 ➡ 15

FIGURE 10

FIGURE 11

Europäisches
Patentamt

European
Patent Office

Office européen
des brevets

# EUROPEAN SEARCH REPORT

Application Number

EP 21 21 2565

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 3 937399 B2 (FUJITSU LTD) 27 June 2007 (2007-06-27) * paragraph [0001] - paragraph [0047]; figures 1-4 * | 1-8 | INV. H03F3/68 H03F3/24 H03F3/58 H03F1/52 |
| A | LEE HAN LIM ET AL: "Reconfigurable 4 x 4 multi-port amplifier with switchable input and output matrices", IET MICROWAVES, ANTENNAS & PROPAGATION, THE INSTITUTION OF ENGINEERING AND TECHNOLOGY, UNITED KINGDOM, vol. 10, no. 12, 17 September 2016 (2016-09-17), pages 1312-1321, XP006058414, ISSN: 1751-8725, DOI: 10.1049/IET-MAP.2015.0783 * paragraph [0001] - paragraph [0004]; figures 1-9 * | 1-8 | H03F3/189 H04B1/74 H03F3/60 |
| A | US 6 014 056 A (RIVIERRE BERNARD [FR]) 11 January 2000 (2000-01-11) * column 1 - column 7; figures 1-5 * | 1-8 | |
| A | US 10 624 051 B2 (BOEING CO [US]) 14 April 2020 (2020-04-14) * column 1 - column 16; figures 1-6 * | 1-8 | TECHNICAL FIELDS SEARCHED (IPC) H03F H04B |

The present search report has been drawn up for all claims

| Place of search | Date of completion of the search | Examiner |
|---|---|---|
| The Hague | 19 May 2022 | Rafflenbeul, A |

EPO FORM 1503 03.82 (P04C01)

## ANNEX TO THE EUROPEAN SEARCH REPORT
## ON EUROPEAN PATENT APPLICATION NO.

EP 21 21 2565

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2022

| Patent document cited in search report | | Publication date | Patent family member(s) | | Publication date |
|---|---|---|---|---|---|
| JP 3937399 | B2 | 27-06-2007 | JP | 3937399 B2 | 27-06-2007 |
| | | | JP | 2004088531 A | 18-03-2004 |
| US 6014056 | A | 11-01-2000 | EP | 0874450 A1 | 28-10-1998 |
| | | | FR | 2762728 A1 | 30-10-1998 |
| | | | JP | H10303662 A | 13-11-1998 |
| | | | US | 6014056 A | 11-01-2000 |
| US 10624051 | B2 | 14-04-2020 | NONE | | |

EPO FORM P0459

For more details about this annex : see Official Journal of the European Patent Office, No. 12/82